# EUROPÄISCHE PATENTANMELDUNG

(11) **EP 2 227 073 A2**
(43) Veröffentlichungstag der Anmeldung: **08.09.2010**
(21) Anmeldenummer: 09015699.3
(22) Anmeldetag: 18.12.2009
(51) Int. Cl.: H05K 1/18

(54) **Elektronisches Bauteil mit aufgenommenem elektronischen Bauelement**

(30) Priorität: 19.12.2008 DE 102008063863
(71) Anmelder: Schneider, Martin, 81479 München (DE)
(72) Erfinder: Schneider, Martin, 81479 München (DE)
(74) Vertreter: Forstmeyer, Dietmar

(57) **Zusammenfassung**

Die Erfindung betrifft ein elektronisches Bauteil (1) mit einem Träger (2) zum Aufnehmen eines elektronischen Bauelements (3) und einem durch den Träger aufnehmbaren elektronischen Bauelement (3). Der Träger (2) weist eine Aussparung (4) zur Aufnahme des elektronischen Bauelements (3) auf und das elektronische Bauelement (3) ist zumindest teilweise in der Aussparung (4) versenkt.

## Beschreibung

Die Erfindung betrifft ein elektronisches Bauteil mit einem Träger zum Aufnehmen eines elektronischen Bauelements und einem aufgenommenen elektronischen Bauelement.

Elektronische Bauteile mit einem Träger und von dem Träger getragenen elektronischen Bauelementen sind allgemein bekannt; beispielsweise konventionelle Platinen mit aufgelöteten elektronischen Bauelementen.

Der Erfindung liegt die Aufgabe zugrunde, ein vorteilhaftes elektronisches Bauteil anzugeben, welches einen Träger zum Aufnehmen eines elektronischen Bauelements aufweist und dazu ein durch den Träger aufgenommenes elektronisches Bauelement.

Die Aufgabe wird gelöst durch ein elektronisches Bauteil mit einem Träger zum Aufnehmen eines elektronischen Bauelements und einem durch den Träger aufnehmbaren elektronischen Bauelement, wobei der Träger eine Aussparung zur Aufnahme des elektronischen Bauelements aufweist und das elektronische Bauelement zumindest teilweise in der Aussparung versenkt ist.

Bevorzugte Ausgestaltungen der Erfindung sind in abhängigen Ansprüchen angegeben und werden im Folgenden näher erläutert.

Die Erfindung beruht auf der Feststellung, dass die bekannten Bauteile mit einem Träger und einem oder mehreren elektronischen Bauelementen relativ hoch gebaut sind. Die Mindesthöhe solcher Bauteile entspricht der Dicke des Trägers, etwa der Platine, plus der Dicke des elektronischen Bauelements, etwa der Dicke eines Silizium-Chips.

Die Erfindung beruht auf der Idee, in dem Träger eine Aussparung zur Aufnahme des elektronischen Bauelements vorzusehen, in welche das elektronische Bauelement oder die elektronischen Bauelemente zumindest teilweise versenkt werden kann/können.

Bei dem Träger kann es sich etwa um konventionelles Platinenmaterial, um eine Glas-, Kunststoffplatte oder auch um einen Keramikträger handeln.

Besonders bevorzugt ist es, das Bauteil insgesamt flach auszulegen; etwa flacher als 2 mm oder sogar flacher als 1 mm. Dies ist vor allem für eine Anwendung als Flächendrucksensor vorteilhaft (vgl. unten).

Vorzugsweise ist der Träger steif. Steife Träger erlauben eine besonders zuverlässige Verarbeitung elektronischer Signale. So tritt bei einem steifen Träger nicht ein für flexible Bauteile bekanntes Problem auf, nämlich, dass die Verarbeitung elektronischer Signale durch Biegen beeinflusst und ggf. fehlerhaft wird. Steife Träger sind besonders bevorzugt, wenn ein Sensor, insbesondere ein Drucksensor, als elektronisches Bauelement verwendet wird, da bei Messungen Fehler besonders unerwünscht sind.

Bei der Aussparung kann es sich etwa um ein durchgehendes Loch in dem Träger oder aber etwa auch um ein Sackloch handeln. Auch unterschiedliche Geometrien der Aussparung sind denkbar. Eine solche kann beispielsweise rund, quadratisch, mehreckig oder als Rinne ausgestaltet sein.

Die Erfindung kann für recht unterschiedliche elektronische Bauelemente vorteilhaft sein. Beispielsweise für Silizium Chips, LED und ganz besonders für Beschleunigungssensoren, insbesondere Kraftsensoren und Drucksensoren, etwa piezoresistive Sensoren.

Piezoresistive Sensoren sind besonders vorteilhaft, da sie grundsätzlich besonders klein gebaut werden können und auch eine besonders große Dynamik aufweisen können, also etwa geeignet sind zur Messung von ganz kleinen Drucken und ganz großen Drucken.

Das erfindungsgemäße elektronische Bauteil kann beispielsweise genau eine Aussparung aufweisen und darin genau ein Bauelement zumindest teilweise versenkt sein. Vorteilhaft können allerdings auch Ausgestaltungen sein mit zwei oder mehr Bauelementen in der Aussparung und/oder auch Träger mit zwei oder mehr, sogar einer Vielzahl, von Aussparungen (s. unten).

Weist der Träger eine Vielzahl an Aussparungen auf, so sind diese vorzugsweise gleichmäßig über ein größeres flächiges Gebiet des Trägers verteilt. Man kann hier von einem so genannten "Array" sprechen. Solche Arrays sind zur Messung einer Größe über eine bestimmte Fläche, etwa den Flächendruck, besonders geeignet.

Die Größe des Trägers, insbesondere seine flächige Ausdehnung, wird in der Regel von der konkreten Anwendung und der benötigten Anzahl der Aussparungen und der elektronischen Bauelemente abhängen. Vorstellbar sind beispielsweise kleine steife Träger, welche gerade so groß sind, dass sie nur eine Aussparung zur Aufnahme des betreffenden elektronischen Bauelements aufweisen können sowie genügend Handhabe für die entsprechenden Anschlüsse bieten. Es ist allerdings auch denkbar, Träger zu benutzen, die eine wesentlich größere Grundfläche aufweisen, als für die Aussparung(en) an sich nötig wäre, beispielsweise um weitere Elektronik auf diesem Träger unterzubringen.

Es kann wünschenswert sein, das elektronische Bauteil beziehungsweise das darin aufgenommene Bauelement vor Umwelteinflüssen zu schützen. Kleine Bauteile können vorteilhaft in ein Elastomer, etwa in eine kleine das Bauteil umgebende Blase, eingegossen werden. Sonst können die Bauelemente auch in ihren Aussparungen vergossen werden, beispielsweise ebenfalls mit einem Elastomer, und/oder eine Schutzschicht aufgebracht werden.

Das Vergießen kann auch die Kontaktierung des elektronischen Bauelements schützen, da Leiter durch die Vergussmasse fixiert werden können. Wird etwa über Drähte kontaktiert und verbiegen diese, lindert die Vergussmasse die mechanischen Auswirkungen auf die Kontaktierung an dem elektronischen Bauelement und verbessert so auch die Signalverarbeitung bzw. reduziert Fehler.

Insgesamt kann das bzw. können die elektronischen Bauelemente sehr gut mit der Erfindung geschützt werden. Die Kombination aus Versenken, vorzugsweise steifem Träger und ggf. zusätzlichem Ein-/Vergießen schützt besonders wirksam. Dies kommt auch der Qualität der elektronischen Signalverarbeitung zu Gute.

Werden die Bauelemente in ihren Aussparungen vergossen, hat es sich als praktisch herausgestellt, einen Ring mit definierter Höhe um die Aussparung zu legen, um das Vergießen zu erleichtern.

Die auf- bzw. eingebrachte Vergussmasse selbst kann der Druckvermittlung zum Sensor hin dienen. Eine druckvermittelnde Druckkugel oder ein entsprechende Zylinder ist in diesem Fall nicht erforderlich.

In anderen Worten: Die Vergussmasse kann als Koppelmedium zwischen Umwelt und Sensor, also dem Bauelement, dienen.

Dabei dient die Vergussmasse zusätzlich dem Schutz insbesondere der Kontaktierung und kann das Bauelement versiegeln.

Da das oder die elektronischen Bauelemente zumindest teilweise in den Aussparungen des Trägers versenkt werden, ist es vorteilhaft, die elektronischen Bauelemente an ihrer Oberseite anzuschließen. Hier können beispielsweise konventionelle Bonding-Verfahren verwendet werden.

Besonders vorteilhaft ist es, die Kontaktierung leicht geschwungen auszuführen. So können mechanische Spannungen reduziert werden; das Risiko für einen Abbruch oder allgemeiner mechanische Spannungen wird verringert. Fehlersignale durch Biegung der kontaktierenden Leiter können verringert oder sogar eliminiert werden.

Der Ausdruck "zumindest teilweise in der Aussparung versenken" bedeutet, dass das betreffende elektronische Bauelement zumindest mit einem Teil seiner Höhe/Tiefe so in den Träger eingelassen ist, dass es teilweise unterhalb einer gedachten bündigen Abdeckung der Aussparung liegt und teilweise oberhalb.

Trägt der Träger auch andere Bauelemente, ist es bevorzugt, das erfindungsgemäße Bauelement zumindest so weit zu versenken, dass es nicht über die nicht versenkten Bauteile übersteht; dies gilt insbesondere, wenn SMD-Technologie eingesetzt wird.

Es ist besonders bevorzugt, das betreffende elektronische Bauelement vollständig in der jeweiligen Aussparung zu versenken. Dann befindet sich das elektronische Bauelement vollständig im Inneren des Trägers, beziehungsweise unterhalb der eben erwähnten gedachten Abdeckung. Ist die Oberfläche des elektronischen Bauelements flächig, wie es beispielsweise bei Drucksensoren der Fall sein kann, ist es auch bevorzugt, wenn diese Oberseite des elektronischen Bauelements und die Oberfläche des Trägers bündig aneinander angeglichen sind.

Bauteile nach der Erfindung können besonders dünn ausgelegt werden, was für zahlreiche Anwendungen sehr vorteilhaft sein kann (siehe unten). Insgesamt können die Bauteile relativ klein ausgelegt werden. Dabei können sie auch, wie oben bereits erwähnt, recht robust ausgelegt werden. Einmal, weil die Bauelemente teilweise versenkt sind, und so gegebenenfalls wenig mechanischen Belastungen ausgesetzt sind, zum Anderen, bei entsprechender Auslegung des Trägers, aufgrund dessen, dass dieser vergleichsweise stabil ist. Bei einer vergleichsweise steifen Auslegung eines erfindungsgemäßen Bauteils werden auch Messfehler durch Verbiegen des Trägers abgemildert oder vielleicht sogar ganz verhindert.

Insgesamt kann daher auch die Genauigkeit dadurch erhöht werden, dass die elektronischen Bauteile, insbesondere Sensoren, in dem Träger versenkt werden.

Es ist an sich bekannt, elektronische Bauelemente mittels Bonding an ihrer Oberseite anzuschließen. Bei Bauteilen beziehungsweise Bauelementen nach der Erfindung kann ebenso vorgegangen werden. Es können also etablierte Technologien für das Anschließen verwendet werden. Daher sind die elektronischen Bauelemente auch leicht anzuschließen. Die Herstellung der Aussparungen, etwa durch Fräsen, stellt ebenfalls kein besonderes Problem dar. Bauteile nach der Erfindung können also auch besonders preisgünstig hergestellt werden.

Bei einer bevorzugten Ausführung des elektronischen Bauteils ist die Aussparung ein Sackloch. Bei einem Sackloch ist das elektronische Bauelement auch an seiner Unterseite durch den Träger gestützt und geschützt. Außerdem lassen sich Sacklöcher besonders leicht vergießen. Auch ist es leichter, elektronische Bauelemente in ein Sackloch einzubringen, als in ein durchgehendes Loch, da diese aus einem Sackloch nicht nach unten herausfallen können.

Bei einer besonders bevorzugten Ausführungsform der Erfindung ist das elektronische Bauelement ein Drucksensor.

Vorzugsweise basiert der Drucksensor auf dem piezoresistiven Effekt.

Bei einer weiteren bevorzugten Ausführungsform sind zumindest zwei elektronische Bauelemente, etwa zur Signalkonditionierung, in derselben Aussparung versenkt; entweder teilweise oder auch vollständig.

Außerdem ist eine Ausführungsform der Erfindung bevorzugt, welche eine Vielzahl Aussparungen in dem Träger zur Aufnahme von jeweils zumindest einem von einer Vielzahl elektronischer Bauelemente aufweist. Auf diese Weise können etwa Flächendrucksensoren realisiert werden.

Als Träger kommt hier beispielsweise ein Folienleiter mit mehreren Verdickungen, beispielsweise mit einer periodischen oder quasi-periodischen Struktur aus Verdickungen, infrage, wobei dann in die Verdickungen jeweils eine Aussparung eingebracht sein kann. Die Verdickungen können vergleichsweise steif sein, was die oben genannten Vorteile mit sich bringt.

Sind eine Vielzahl von Aussparungen vorgesehen, ist es bevorzugt diese matrixförmig anzulegen. Hier kommen beispielsweise hexagonale oder auch rechteckige Verteilungen der Aussparungen infrage.

Vorteilhaft ist es auch, mehrere oder viele einzelne kleine steife Träger mit zugehörigem/n Bauelement/en auf einen Folienleiter oder einer sonstigen flexiblen Unterlage aufzubringen. Dazu können die einzelnen Träger so ausgelegt werden, dass sie in SMD-Technologie aufgebracht werden können. Es ist auch möglich, die einzelnen Träger in einen Folienleiter zu integrieren oder über eine sonstige dünne und vorzugsweise auch flexible Schicht mechanisch und/oder elektrisch miteinander zu verbinden. Grundsätzlich können die einzelnen Träger auch in ein Netz aus Anschlussleitungen eingebunden sein; die Bauteile wären hier die Knoten.

Grundsätzlich kann eine Mehrzahl einzelner Träger auch auf einer gemeinsamen Platte befestigt sein.

Grundsätzlich ist die Erfindung auch auf Anwendungen des erfindungsgemäßen Bauteils gerichtet, insbesondere auf folgende Verwendung:

Verwendung als Messeinrichtung für Flächendruck.

Es wird also der Druck als Funktion der Fläche gemessen. Dies kann insbesondere punktuell mit Hilfe mehrerer Sensoren geschehen.

Beispielsweise ermöglicht es die Erfindung auf vorteilhafte Weise die Druckverteilung auf der Haut eines Menschen oder eines Tieres zu messen; auch an Stellen, die besondere Anforderungen an die Anpassbarkeit des Flächendrucksensors stellen, etwa an Gelenken oder Extremitäten. So kann etwa ein Folienleiter mit zahlreichen kleinen steifen Bauteilen nach der Erfindung hier eingesetzt werden; die Bauteile können dabei etwa so klein gewählt werden, dass sie sich in Unebenheiten der zu messenden Oberfläche einfügen, der Flächendrucksensor der Oberfläche also ohne großen Fehler folgen kann.

Die Erfindung erlaubt es etwa auf vorteilhafte Weise, den Anpressdruck von Verbänden in der Orthopädietechnik zu messen.

Weitere Anwendungen können sein:
die Messung des Flächendrucks in einer Schuhsohle; Bauteile nach der Erfindung können dazu in der Schuhsohle eingebettet sein;
die Messung des Flächendrucks in einem Sitz, etwa einem Autositz;
die Messung des Flächendrucks in oder unter einem Sattel, insbesondere einem Pferdesattel; Bauteile nach der Erfindung könnten dazu in den Sattel eingebettet sein oder in die Satteldecke;
die Messung des Flächendrucks in einem Fahrradsattel.

Die Bauteile nach der Erfindung sind besonders gut handhabbar. Für einige Anwendungen lassen sie sich gegebenenfalls sogar manuell verlöten. Insbesondere kann die Kontaktierung robust ausgelegt werden - weiter sind die Bauteile bei weitem nicht so bruchempfindlich, wie etwa ein Dice (Silizium-Bauelement in Würfelform).

Solche Dice sind etwa als Gasdrucksensoren zur Messung des absoluten Gasdrucks bekannt.

Der Träger hält und schützt das Bauelement, etwa den Dice, und schützt es so insbesondere vor Bruch. Weiter trägt bzw. hält der Träger auch die Kontaktierung für das Bauelement. Die Kontaktierung wird stabil gehalten; ein Verbiegen kann zumindest weitgehend vermieden werden, was sich insbesondere positiv auf die Signalverarbeitung auswirkt. Insbesondere kann der Träger die Bond-Terminals, die Anschlussstellen fürs Bonden, sicher aufnehmen. Der Träger schützt vor Verbiegung der sensiblen Strukturen.

Insbesondere kann so eine Mehrzahl Bauteile flexibel miteinander verbunden sein, und so ein flexibles Ganzes darstellen, wobei trotzdem jedes einzelne Bauelement in dem jeweiligen Bauteil gut geschützt sein kann.

Insbesondere bei der Verwendung von piezoresistiven Bauelementen können unabhängig von den genannten Flächendruckmessungsanwendungen oder auch in Kombination mit diesen, Schwingungsanalysen durchgeführt werden. Piezoresistive Bauelemente sind für Schwingungsanalysen besonders vorteilhaft, da sie über eine hohe Grenzfrequenz verfügen können.

Ein weiterer Vorteil von piezoresistiven Bauelementen ist, dass sie besonders wenig Alterungsdrift und Temperaturdrift aufweisen können.

Insbesondere kann mit der Erfindung auch der Anpressdruck zweier elastischer Flächen gemessen werden. Hier ist es vorteilhaft, möglichst wenig bzw. kleine Störkörper zu haben.

Weiter richtet sich die Erfindung grundsätzlich auch auf ein Herstellungsverfahren für ein erfindungsgemäßes Bauteil. Dieses weist zumindest folgende Schritte auf:
Zur Verfügung stellen eines Trägers zum Aufnehmen eines elektronischen Bauelements,
zur Verfügung stellen eines elektronischen Bauelements, Einbringen einer Aussparung zur Aufnahme des elektronischen Bauelements in den Träger und
zumindest teilweises Versenken des elektronischen Bauelements in der Aussparung.

Anschließend kann das elektronische Bauelement beispielsweise in der Aussparung vergossen werden und/oder aber auch eine Schutzschicht auf Träger und Bauelement aufgelegt werden. Es bietet sich aus oben genannten Gründen an, das Bauelement an seiner Oberseite an den Anschlüssen zu befestigen.

Ein Verguss schütz zusätzlich die Kontaktierung des Bauelements. Beispielsweise sind Bond-Drähte an sich empfindlich. Weiter kann der Verguss auch vor Licht schützen.

Wird ein Siliziumbauteil als Druckmesser verwendet, kann dieses insbesondere eine Membran enthalten, über die die eigentliche Druckmessung erfolgt. Der Druck von Außen kann vorteilhaft über die Vergussmasse vermittelt werden.

Grundsätzlich kann die Vergussmasse auch mit einer Gießschablone appliziert werden oder die Fließreichweite über die Viskosität eingestellt werden, so dass nur die zu bedeckenden Abschnitte auch bedeckt werden.

Die vorstehende und die folgende Beschreibung der einzelnen Merkmale beziehen sich sowohl auf die Vorrichtungskategorie als auch auf die Verwendungs- bzw. Herstellungsverfahrenskategorie, ohne dass dies im Einzelnen in jedem Fall erwähnt ist; die dabei offenbarten Einzelmerkmale können auch in anderen als den gezeigten Kombinationen erfindungswesentlich sein.

Im Folgenden soll die Erfindung auch anhand von Ausführungsbeispielen näher erläutert werden, ohne dabei die Erfindung auf die Beispiele einschränken zu wollen:
Figur 1 zeigt eine schematische Darstellung eines Trägers und eines elektronischen Bauelements nach der Erfindung von der Seite.
Figur 2 zeigt eine schematische Sicht auf und unter einen Träger nach der Erfindung.

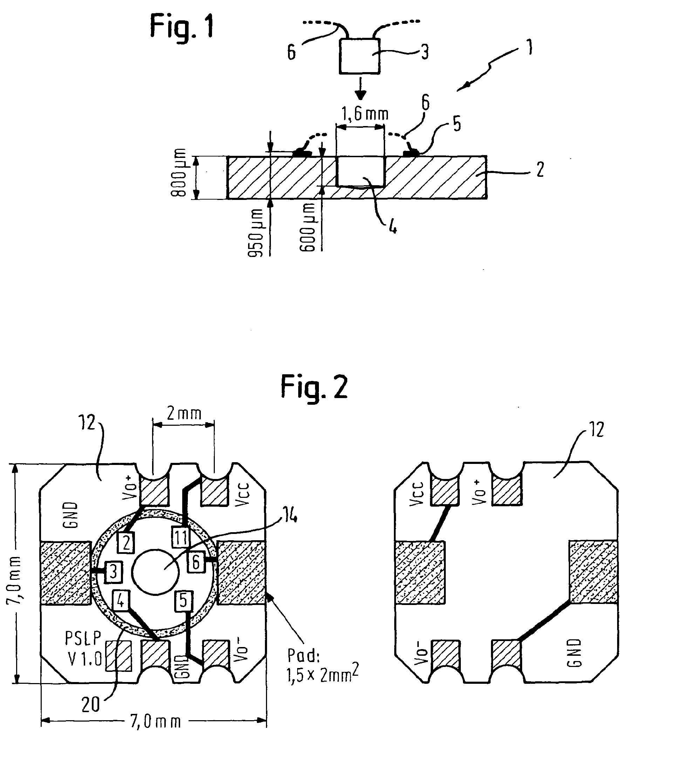

In Figur 1 ist schematisch ein elektronisches Bauteil (1) nach der Erfindung dargestellt. Man erkennt einen Träger (2) aus einem konventionellen Platinenmaterial mit einer ausgefrästen Aussparung (4). Oberhalb des Trägers (2) ist schematisch ein elektronisches Bauelement (3) dargestellt. Hierbei handelt es sich um einen piezoresistiven Drucksensorchip (3). Der Pfeil unterhalb des Drucksensors (3) deutet an, dass dieser in der Aussparung (4) zu versenken ist. Auf der Oberfläche des Trägers (2) sind so genante Anschlusspads (5) gezeigt, an welchen Anschlüsse (6) für den Drucksensor (3) angebracht sind.

Die Anschlüsse (6) sind oben an das elektronische Bauelement (3) angeschlossen. Insgesamt kann zum Anschließen des elektronischen Bauelements eine konventionelle Bondingtechnik verwendet werden.

Im zusammengesteckten Zustand ist das elektronische Bauelement (3) vollständig in der Aussparung (4) des Trägers (2) versenkt.

Wird ein Silizium-Bauelement, etwa ein Dice, eingesetzt, kann sich beispielsweise insgesamt eine Bauhöhe von 0.9 mm ergeben, wobei dies nur etwa 300 Mikrometer höher ist als die Höhe des Silizium-Bauelements. Grundsätzlich gilt, dass eine noch geringere Bauhöhe durchaus wünschenswert ist, solange dadurch nicht die Handhabbarkeit oder die Robustheit allzu nachteilig beeinflusst werden. Der Durchmesser des Bauteils kann beispielsweise 3 mm betragen, wobei auch hier ein geringerer Durchmesser vorteilhaft sein kann. Auch hier sollte allerdings die Miniaturisierung nicht so weit getrieben werden, dass das Bauelement nicht mehr durch den Träger geschützt ist.

Figur 2 zeigt links eine Aufsicht eines Trägers (12) und rechts eine Ansicht von unten auf denselben Träger (12).

In beiden Ansichten erkennt man deutlich die schraffierten Flächen, die so genannten Pads, zum Anschluss des elektronischen Bauelements (hier nicht gezeigt).

In der linken Abbildung schaut man senkrecht von oben in ein Sackloch zur Aufnahme eines elektronischen Bauelements.

Weiter erkennt man in der linken Abbildung auch einen auf die Oberfläche des Trägers (12) aufgelegten Ring (20). Dieser Ring stellt eine Hilfe beim späteren Verfüllen des Sacklochs (14) dar.

Wird der Anpressdruck von einem Gegenstand, gegebenenfalls mit elastischer anpressender Fläche, und dem Bauteil gemessen, kann die Vergussmasse den Druck zum Sensor vermitteln.

Das Bauteil selbst kann zur Anwendung ebenfalls versenkt werden, etwa in einem Verband, einer Satteldecke oder einer anderen elastischen Aufnahme. So kann besonders gut gewährleistet werden, dass das Bauteil nicht zu stark verformend auf die zu messende Anpressfläche einwirkt, was die Messung verfälschen könnte.

Die Höhe eines erfindungsgemäßen Bauteils kann etwa 0.6 mm unterschreiten. Die Breite des Trägers kann kleiner 8 mm gewählt werden; besonders kleine Träger können etwa eine Breite von 0.8 mm aufweisen. Idealerweise ist die Bauhöhe des Bauteils insgesamt kaum höher als die des Bauelements, etwa eines Sensors.

Wird das Bauteil besonders klein ausgelegt, kann besonders nahe an der Kontaktierung eingekoppelt werden. Auslenkungen der kontaktierenden Leiter können so besonders klein gehalten werden; somit können auch Bewegungen am Kontakt klein gehalten werden.

Der Umfang des Rings bzw. die mit seiner Hilfe eingebrachte Verfüllung definiert ein Fenster. Das Bauteil kann so ausgelegt werden, dass ein in das Sackloch (14) eingebrachter Drucksensor nur für Druck empfänglich ist, der innerhalb dieses Fensters von Außen auf die Verfüllung wirkt. Ein Druck auf die umgebenden seitlichen Teile des Trägers (2) wirkt dann nicht auf den Sensor.

Das Bauteil kann so ausgelegt werden, dass sich die Kontaktierung des Bauelements, etwa die so genannten Bonds, im Einsatz nur um wenige Nanometer bewegt. Wird beispielsweise ein Silizium-Bauelement, etwa ein Dice, als Druckmesser eingesetzt und ist dieser mit einer Membran versehen, so kann das Bauteil weiter so ausgelegt werden, dass auch die Membran sich nur einige Nanometer bewegt. Insgesamt können die Kontaktierungen des Bauelements und das Bauelement so gut geschützt werden; die Kontaktierung ist besonders bruchfest.

Sowohl in Figur 1 als auch in Figur 2 sind exemplarisch einige der Dimensionen angegeben.

Insgesamt ermöglicht die Erfindung mobil einsetzbare und zuverlässig kontaktierte Bauteile. Diese können sehr klein, insbesondere besonders flach bzw. dünn, und robust ausgelegt werden und können auch über eine besonders genaue bzw. zuverlässige Signalverarbeitung verfügen. Beispielsweise können auch thermische Drift und Altersdrift besonders gering ausfallen. Die Reproduzierbarkeit der Signale kann besonders gut ausfallen; beispielsweise können Variationen von Messung zu Messung kleiner sein als 2%. Insbesondere kann mit der Erfindung ein Absolutdrucksensor realisiert werden.

## Patentansprüche

1. Elektronisches Bauteil (1) mit
einem Träger (2) zum Aufnehmen eines elektronischen Bauelements (3) und einem durch den Träger (2) aufnehmbaren elektronischen Bauelement (3), wobei
der Träger (2) eine Aussparung (4) zur Aufnahme des elektronischen Bauelements (3) aufweist und das elektronische Bauelement (3) zumindest teilweise in der Aussparung (4) versenkt ist.

2. Elektronisches Bauteil (1) nach Anspruch 1, bei dem das elektronische Bauelement (3) vollständig in der Aussparung (4) versenkt ist.

3. Elektronisches Bauteil (1) nach Anspruch 1 oder 2, bei dem die Aussparung (4) ein Sackloch ist.

4. Elektronisches Bauteil (1) nach einem der vorangehenden Ansprüche, bei dem das elektronische Bauelement (3) ein Drucksensor ist.

5. Elektronisches Bauteil (1) nach Anspruch 4, bei dem der Drucksensor (3) ein piezoresistiver Sensorchip ist.

6. Elektronisches Bauteil (1) nach einem der vorangehenden Ansprüche mit zumindest zwei elektronischen Bauelementen (3), welche beide in derselben Aussparung (4) zumindest teilweise versenkt sind.

7. Elektronisches Bauteil (1) nach Anspruch 6, mit einer Vielzahl Aussparungen (4) in dem Träger (2) zur Aufnahme von jeweils zumindest einem von einer Vielzahl elektronischer Bauelemente (3).

8. Elektronisches Bauteil (1) nach Anspruch 7, bei dem die Aussparungen (4) matrixartig angelegt sind.

9. Verwendung eines elektronischen Bauteils (1) nach einem der Ansprüche 1 bis 8 zur Messung von Druck.

10. Verwendung nach Anspruch 9, bei der das elektronische Bauteil (1) zur Messung von Flächendruck eingesetzt wird.

11. Verfahren zur Herstellung eines elektronischen Bauteils (1) nach einem der Ansprüche 1 bis 8 mit den Schritten:
zur Verfügung stellen eines Trägers (2) zum Aufnehmen eines elektronischen Bauelements (3),
zur Verfügung stellen eines elektronischen Bauelements (3), Einbringen einer Aussparung (4) zur Aufnahme des elektronischen Bauelements (3) in den Träger (2) und
zumindest teilweises Versenken des elektronischen Bauelements (3) in der Aussparung (4).
